# EUROPÄISCHE PATENTSCHRIFT

(11) **EP 0 978 148 B1**
(45) Veröffentlichungstag und Bekanntmachung des Hinweises auf die Patenterteilung: **19.05.2004**
(21) Anmeldenummer: 98958203.6
(22) Anmeldetag: 21.10.1998
(51) Int. Cl.: H01L 41/083

(54) **PIEZOELEKTRISCHER AKTOR**
PIEZOELECTRIC ACTUATOR
ACTIONNEUR PIEZO-ELECTRIQUE

(30) Priorität: 22.01.1998 DE 19802302
(43) Veröffentlichungstag der Anmeldung: 09.02.2000
(73) Patentinhaber: ROBERT BOSCH GMBH, 70442 Stuttgart (DE)
(72) Erfinder: HEINZ, Rudolf, D-71272 Renningen (DE); SCHMOLL, Klaus-Peter, D-74251 Lehrensteinsfeld (DE); BÖCKING, Friedrich, D-70499 Stuttgart (DE)
(86) Internationale Anmeldenummer: PCT/DE1998/003075
(87) Internationale Veröffentlichungsnummer: WO 1999/038220

(56) Entgegenhaltungen:
- US-A- 5 153 477
- PATENT ABSTRACTS OF JAPAN vol. 016, no. 530 (E-1287), 30. Oktober 1992 -& JP 04 197086 A (HITACHI LTD), 16. Juli 1992
- PATENT ABSTRACTS OF JAPAN vol. 097, no. 001, 31. Januar 1997 -& JP 08 242023 A (HITACHI METALS LTD), 17. September 1996

## Beschreibung

### Stand der Technik

Die Erfindung geht aus von einem piezoelektrischen Aktor, wie er z. B. aus der DE 37 13 697 A1 bekannt ist.

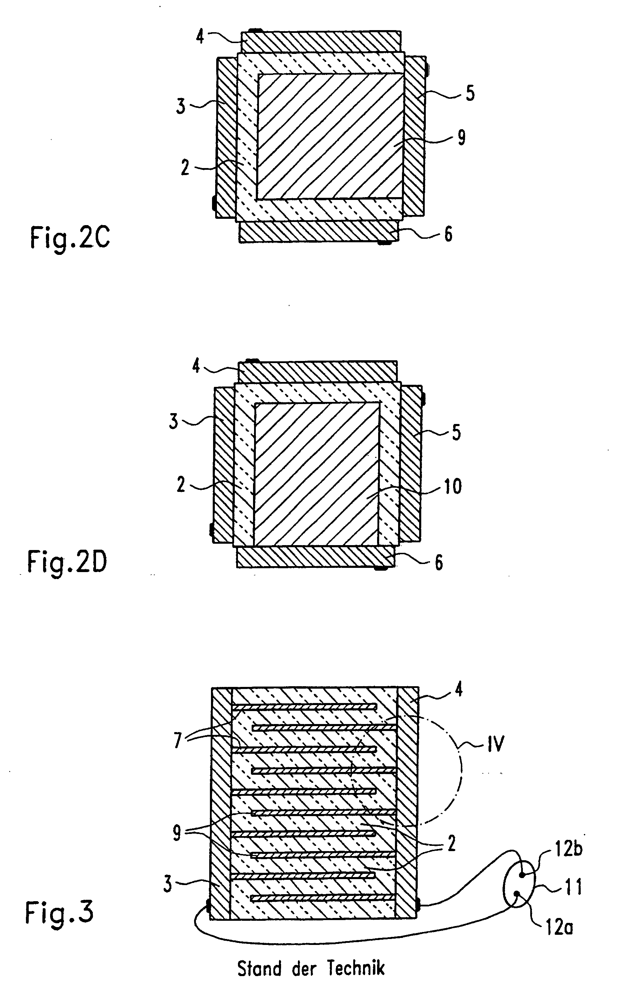

Piezoelektrische Aktoren bestehen, wie in Fig. 3 schematisch dargestellt, üblicherweise aus mehreren stapelartig übereinander angeordneten Scheiben 2 aus einem piezoelektrischen Material, sogenannten Piezoelementen, wobei die Stapelrichtung in Richtung der gemeinsamen Polarisationsrichtung der piezoelektrischen Scheiben gewählt ist. An zwei Seitenflächen des Stapels bzw. Piezostacks ist jeweils eine Außenelektrode 3, 4 angebracht, die mit einem Anschluß 12a, 12b einer Steuerspannungsquelle 11 elektrisch verbindbar ist. Zwischen den piezoelektrischen Scheiben 2 sind jeweils die Innenelektroden 7, 9 des piezoelektrischen Aktors 1 angeordnet. Die Innenelektroden 7, 9 sind dabei im Wechsel jeweils nur mit einer der Außenelektroden 3, 4 elektrisch durchkontaktiert, so daß die benachbart übereinander angeordneten Innenelektroden 7 und 9 jeweils mit den verschiedenen Anschlüssen 12a und 12b der Steuerspannungsquelle 11 elektrisch verbunden sind.

Bei dieser Anordnung eines piezoelektrischen Aktors ist jedes Piezoelement 2 an beiden Scheibenoberflächen mit einer Elektrode 7, 9 verbunden, die über die Außenelektroden 3, 4 mit einer elektrischen Spannung beaufschlagbar sind. Bei Beaufschlagung mit der Spannung dehnt sich jedes der stapelartig übereinander angeordneten, scheibenartigen Piezoelemente 2 in Richtung des zwischen den Elektroden 7, 9 entstehenden elektrischen Feldes, dessen Richtung mit der Polarisationsrichtung der piezoelektrischen Scheiben 2 zusammenfällt, aus. Durch die große Anzahl der gestapelten Piezoelemente 2 ist ein relativ großer Hub der Gesamtanordnung bei gleichzeitig relativ kleiner Ansteuerspannung erreichbar.

Piezoelektrische Aktoren der oben beschriebenen Art können zu verschiedenen Zwecken verwendet werden, beispielsweise zur Betätigung eines Ventilschließkörpers eines Brennstoffeinspritzventils, zur Betätigung von Hydraulikventilen, zum Antrieb von Mikropumpen, zur Betätigung von elektrischen Relais, und dergleichen. Aus dem Stand der Technik sind bereits verschiedene solcher Anwendungsmöglichkeiten bekannt.

Aus der EP 0 361 480 B1 ist beispielsweise eine , Kraftstoff-Einspritzdüse für Verbrennungskraftmaschinen bekannt, bei der zum Öffnen und Schließen der Einspritzdüse die Ventilnadel in Hubbewegungen versetzt wird. Das Antriebselement für diese Hubbewegungen besteht dabei aus einem Stapel piezoelektrisch anregbarer Scheiben, die mit flächigen Elektroden versehen sind.

Ein weiteres Einspritzventil für Kraftstoffeinspritzsysteme in Brennkraftmaschinen, wie direkt einspritzende Dieselmotoren und dergleichen, ist aus der DE 35 33 085 A1 bekannt, das ebenfalls zum Öffnen und Schließen des Ventils durch Hubbewegung bzw. Verschieben der Ventilnadel ein piezoelektrisches Stellglied aufweist. Das piezoelektrische Stellglied besteht auch hier aus einer Vielzahl von scheibenförmigen Piezoelementen und ist über eine anlegbare Spannung in sehr kurzer Zeit in seiner axialen Richtung verlängerbar bzw. verkürzbar.

Ferner ist in der DE 38 00 203 C2 ein Kraftstoffeinspritzventil mit einem piezokeramischen Ventilstellglied mit aufeinander geschichteten Piezo-Keramikplatten mit Spannungszuführungen zu jeder Piezo-Keramikplatte offenbart. Das besondere Kennzeichen des bei diesem Einspritzventil verwendeten piezoelektrischen Aktors ist die Aufeinanderschichtung von gepaarten Keramikplatten entgegengesetzter Polarität, um auf diese Weise den Stellweg des piezokeramischen Ventils zu vergrößern.

Als weitere Anwendungsmöglichkeit für piezoelektrische Aktoren ist aus der EP 0 477 400 A1 eine Anordnung für einen Wegtransformator eines piezoelektrischen Aktors bekannt, die eine Hubvergrößerung des piezoelektrischen Aktors schaffen soll.

In den oben beispielhaft aufgeführten Druckschriften, die jeweils eine mögliche Anwendung für piezoelektrische Aktoren der eingangs genannten Art offenbaren, sind der Aufbau und die Funktionsweise der verwendeten piezoelektrischen Aktoren zwar nicht im einzelnen beschrieben, sie entsprechen aber im wesentlichen denjenigen oben anhand von Fig. 3 beschriebenen Aktoren.

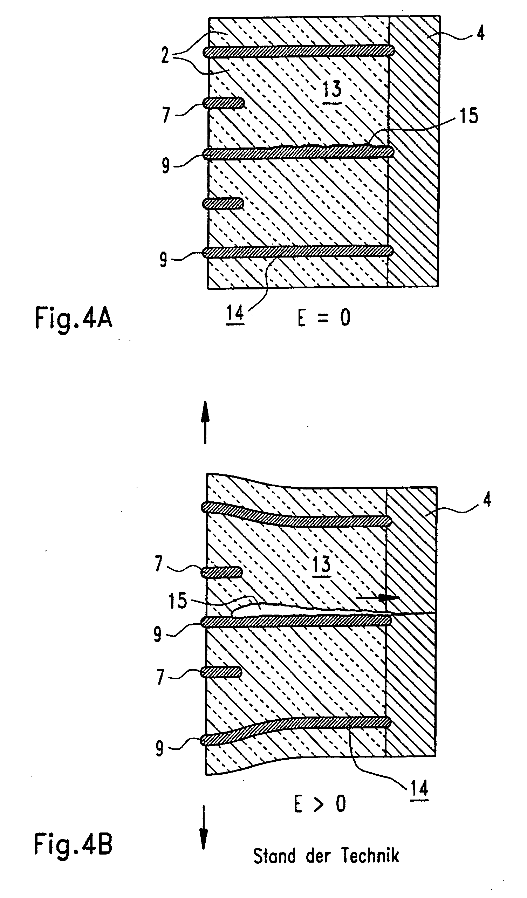

Bei den herkömmlichen piezoelektrischen Aktoren tritt die piezoelektrisch erzeugte Dehnung wegen der Verbindung der gestapelten Piezoelemente 2 und Innenelektroden 7, 9 mit den beiden Außenelektroden 3, 4 hauptsächlich nur im mittleren Bereich auf, wo sich die Innenelektroden 7 und 9 gegenüberstehen. In den Randzonen 13, wo sich die Innenelektroden 7 und 9 nicht direkt gegenüberstehen, entsteht ein Bereich mit geänderter Feldstärke und demzufolge auch Zugspannungen. Aufgrund dieser Zugspannungen kommt es in solchen Aktoren häufig zu Rißbildungen. Die Entstehung solcher Risse wird im folgenden anhand der Fig. 4A und B näher erläutert. Dabei zeigt Fig. 4A den Aktor 1 im neutralen Zustand, d.h. ohne angelegte Steuerspannung, und Fig. 4B zeigt den Aktor 1 im Betrieb, d.h. mit angelegter Steuerspannung und daraus resultierender Dehnung der Piezoelemente 2.

Die Fig. 4A und 4B zeigen den Ausschnitt IV eines konventionellen piezoelektrischen Aktors gemäß Fig. 3 in vergrößerter Darstellung. In dem Grenzgebiet zwischen dem Stapel aus Piezoelementen 2 und Innenelektroden 7, 9 und den Außenelektroden 3, 4 kann man zwei Bereiche 13, 14 unterscheiden. In dem einen Bereich 13 ist die Innenelektrode 7 nicht bis zu der Außenelektrode 4 durchkontaktiert und die für das Piezoelement 2 üblicherweise verwendete Keramik ist in diesem Bereich 13 durchgesintert. In dem anderen Bereich 14 ist die Innenelektrode 9 zu der Außenelektrode 4 durchgeführt, hat aber keinen Kontakt zu der anderen Außenelektrode 3. Die Haftfestigkeit im zweiten Bereich 14, d.h. zwischen Piezoelement 2 und Innenelektrode 9, ist um den Faktor 3 bis 5 kleiner als die Haftfestigkeit in dem Bereich 13 innerhalb des piezoelektrischen Materials. Bei Anlegen einer Steuerspannung kommt es in der Mitte des Aktors 1 zu größeren Dehnungen als im Grenzgebiet zu den Außenelektroden, wie in Fig. 4B veranschaulicht. Durch die dadurch entstehenden großen Zugspannungen in den Bereichen 13, 14 des Aktors 1 kommt es häufig zu Rißbildungen 15 an der Grenze zwischen den Innenelektroden 9 und den Piezoelementen 2 im Bereich 14. Beim weiteren Betrieb des Aktors 1 setzen sich diese Risse 15 bis in die Außenelektrode 4 fort, wodurch die Kontaktierung der Innenelektroden 9 zumindest teilweise erheblich verschlechtert oder sogar unterbrochen wird und somit die Gesamtdehnung des Aktors 1 verringert wird.

Aus der JP 4-197086 A ist bereits ein piezoelektrischer Aktor bekannt, der eine Vielzahl von Scheiben aus einem piezoelektrischen Material aufweist. Die Keramik-Scheiben haben eine Polarisationsrichtung senkrecht zur Scheibenebene und sind in Richtung ihrer Polarisationsrichtung in einer Stapelrichtung übereinander gestapelt. Dabei sind beispielsweise zwei, drei oder vier Außenelektroden am Umfang des Piezostapels angebracht. Der Piezostack wird zudem von einer Vielzahl von Innenelektroden gebildet, die jeweils zwischen den piezoelektrischen Scheiben angeordnet sind, wobei zusätzlich Isolationsglasscheiben in dem Piezoaktor eingebracht sind. Der piezoelektrische Aktor ist dabei so aufgebaut, dass sich zwei Keramikscheiben mit jeweils einer Innenelektrode und darauf folgend zwei Keramikscheiben mit jeweils einer Isolationsglasscheibe abwechseln, wobei dieser Zyklus in Stapelrichtung mehrfach folgend fortgesetzt ist. Die Innenelektroden sind jeweils auf zwei gegenüberliegenden Seiten an den Außenelektroden durchkontaktiert.

### Vorteile der Erfindung

Der piezoelektrische Aktor mit den Merkmalen des Anspruchs 1 hat den Vorteil, daß durch den Aufbau des Aktors mit zwei Gruppen von jeweils mindestens zwei Außenelektroden die Bereiche mit den Durchkontaktierungen der Innenelektroden zu den Außenelektroden auf mehr Seitenflächen des Aktors verteilt werden, damit in Stapelrichtung weiter voneinander beabstandet und gleichzeitig bei jeder Innenelektrode drei Randzonen durchgesintert werden können. Durch diese Maßnahme können die Zugspannungen im Aktor verringert und somit die Neigung zur Rißbildung allgemein und insbesondere in den Randzonen deutlich vermindert werden. Ein weiterer Vorteil der Erfindung besteht darin, daß durch die Verwendung von insgesamt vier Außenelektroden die Wärmeableitung des Aktors deutlich verbessert wird.

Besonders vorteilhaft ist die zyklische Reihenfolge der Kontaktierungen zwischen den Innenelektroden und den verschiedenen Außenelektroden. Hierdurch werden die Bereiche der Durchkontaktierungen gleichmäßig bei gleichzeitig möglichst großem Abstand voneinander auf den gesamten Aktor verteilt, wodurch bei einer evtl. Rißbildung die Möglichkeiten einer Rißüberbrückung an den Außenelektroden deutlich erleichtert wird. Gemäß einer Weiterbildung der Erfindung werden für eine solche Rißüberbrückung an den Außenflächen der Außenelektroden Wellelektroden angebracht, deren Wellenlänge das Vierfache des Abstandes zweier aufeinanderfolgender Innenelektroden beträgt. Bei herkömmlichen piezoelektrischen Aktoren würde die Wellenlänge nur halb so groß sein und die Gefahr einer flächigen Verlötung der Wellelektroden mit den Außenelektroden bestehen.

Durch die in den Unteransprüchen aufgeführten Maßnahmen sind vorteilhafte Weiterbildungen und Verbesserungen des im Anspruch 1 angegebenen piezoelektrischen Aktors möglich.

### Zeichnung

Ein Ausführungsbeispiel der Erfindung ist in der Zeichnung vereinfacht dargestellt und in der nachfolgenden Beschreibung näher erläutert. Es zeigen
- Fig. 1: ein Ausführungsbeispiel eines piezoelektrischen Aktors in einer geschnittenen Darstellung entlang der Linie I-I in Fig. 2A,
- Fig. 2A bis D: den piezoelektrischen Aktor von Fig. 1 in den Draufsichten auf die verschiedenen Ebenen der Innenelektroden in bzw. parallel zu der Schnittebene II-II in Fig. 1,
- Fig. 3: einen piezoelektrischen Aktor in einer geschnittenen Darstellung nach dem Stand der Technik, und
- Fig. 4A und B: einen Ausschnitt IV des piezoelektrischen Aktors von Fig. 3 in vergrößerter Darstellung zur Veranschaulichung der Rißbildung bei herkömmlichen piezoelektrischen Aktoren.

### Beschreibung der Ausführungsbeispiele

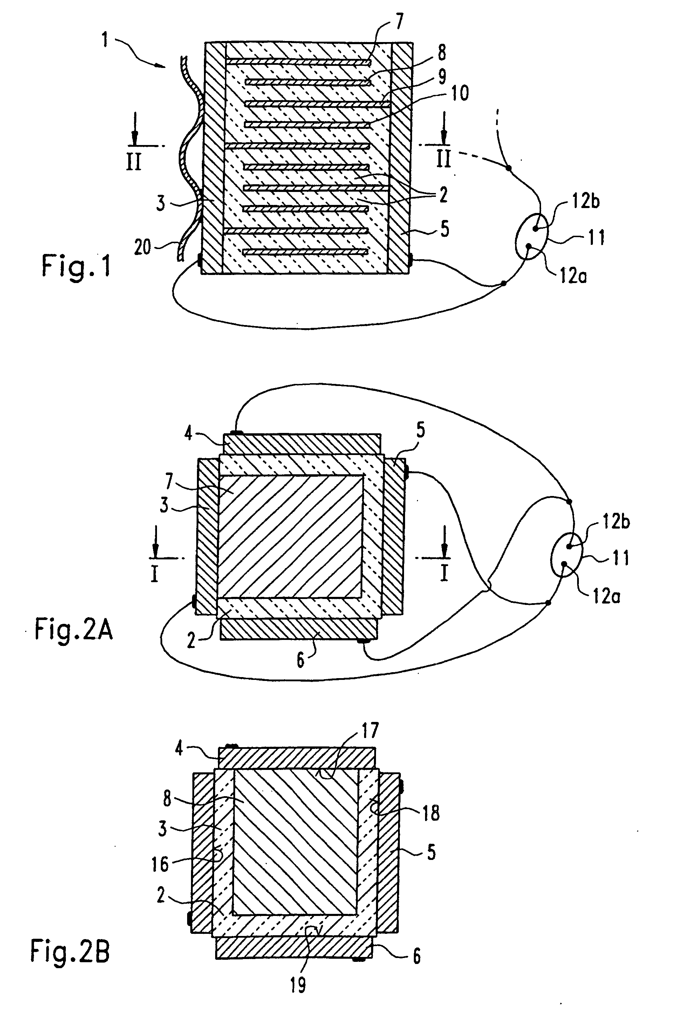

In den Fig. 1 und 2 ist beispielhaft ein bevorzugtes Ausführungsbeispiel eines piezoelekrischen Aktors 1 gemäß der vorliegenden Erfindung dargestellt. Dabei zeigt Fig. 1 den piezoelektrischen Aktor 1 in geschnittener Darstellung gemäß der Linie I-I in Fig. 2A, und die Fig. 2A bis D zeigen die Anordnung der Innenelektroden 7, 8, 9 und 10 gemäß Schnitt II-II in Fig. 1, bzw. parallel zum Schnitt II-II in Fig. 1.

Wie bei den konventionellen piezoelektrischen Aktoren besteht der piezoelektrische Aktor 1 aus einer Vielzahl von Scheiben 2 aus einem piezoelektrischen Material, deren Polarisationsrichtung im wesentlichen senkrecht zur Scheibenebene verläuft und die in Richtung ihrer gemeinsamen Polarisationsrichtung übereinander gestapelt sind, um einen sogenannten Piezostapel (Piezostack) zu bilden. Als piezoelektrisches Material für die Piezoelemente 2 kann zum Beispiel Quarz, Turmalin, Bariumtitanat (BaTiO₃) oder spezielle Piezokeramiken, wie vorzugsweise ein Bleizirkonat-Bleititanat- oder das PZT-System (PbZrO₃-PbTiO₃) eingesetzt werden. Geeignet sind aber auch organische Salze, wie NaK-Tartrat oder eine Vielzahl anderer bekannter piezoelektrischer Materialien.

Zwischen den einzelnen piezoelektrischen Scheiben 2 ist jeweils eine Innenelektrode 7, 8, 9, 10 angeordnet. An den Seitenflächen 16, 17, 18, 19 des Piezostapels ist jeweils über die gesamte Höhe des Piezostapels eine Außenelektrode 3, 4, 5, 6 angebracht, die beispielsweise in Form einer auf die Seitenfläche aufgebrachten Lotschicht gebildet sein kann. Jede Innenelektrode 7, 8, 9, 10 ist mit jeweils nur einer Außenelektrode 3, 4, 5, 6 kontaktiert, d.h. die Innenelektroden 7-10 erstrecken sich in dem Piezostapel jeweils nur zu einer Seitenfläche 16, 17, 18 oder 19 hin, während sie zu den übrigen Seitenflächen 16-19 bzw. zu den übrigen Außenelektroden 3-6 beabstandet sind, wie in den Fig. 2A bis 2D für die in Stapelrichtung aufeinander folgenden Innenelektroden 7-10 gezeigt. In den nicht durchkontaktierten Bereichen 13 ist die Piezokeramik 2 jeweils durchgesintert.

Um die gewünschte Wirkung des piezoelektrischen Aktors 1 zu erzielen, erfolgt die Verschaltung der Innen- und Außenelektroden wie folgt. Die Außenelektroden 3-6 sind in zwei Gruppen 3, 5 und 4, 6 unterteilt, welche jeweils mit einem Anschluß 12a bzw. 12b einer Steuerspannungsquelle 11 elektrisch verbunden werden können. Die Innenelektroden 7-10 kontaktieren die Außenelektroden 3-6 derart, daß jeweils eine Innenelektrode 7, 9 mit dem einen Anschluß 12a der Steuerspannungsquelle 11 und die in Stapelrichtung nächste Innenelektrode 8, 10 mit dem anderen Anschluß 12b, der Steuerspannungsquelle 11 elektrisch verbunden ist. Hierdurch ist jedes scheibenförmige Piezoelement 2 an seinen beiden Scheibenoberflächen mit Elektroden 7, 9 bzw. 8, 10 verbunden, die über die Außenelektroden 3, 5 und 4, 6 mit einer elektrischen Spannung aus der Steuerspannungsquelle 11 beaufschlagbar sind. Wie bei den herkömmlichen piezoelektrischen Aktoren dehnt sich bei Beaufschlagung mit der Spannung jedes der stapelartig übereinander angeordneten Piezoelemente 2 in Richtung des zwischen den Elektroden 7, 9 und 8, 10 entstehenden elektrischen Feldes, dessen Richtung mit der Polarisationsrichtung der piezoelektrischen Scheiben 2 zusammenfällt, aus. Durch die große Anzahl der gestapelten Piezoelemente 2 ist ein relativ großer Hub der Gesamtanordnung erreichbar, wobei der Hub aufgrund der festen Verbindung der gestapelten Piezoelemente 2 mit den Außenelektroden 3-6 nur im mittleren Bereich zwischen diesen Außenelektroden 3-6 möglich ist.

Weiter sei angemerkt, daß die Verwendung von insgesamt vier Außenelektroden 3-6 gegenüber den herkömmlich verwendeten zwei Außenelektroden 3-4 auch zu einer verbesserten Wärmeableitung des Aktors 1 führt. Die Wärmeleitfähigkeiten der Piezokeramiken sind nämlich bekanntermaßen gering im Vergleich zu denen von Metallen.

Um gemäß der vorliegenden Erfindung die Neigung zu Rißbildungen im piezoelektrischen Aktor 1, wie sie oben anhand der Fig. 4A und B erläutert wurde, zu verringern, erfolgen die Kontaktierungen der Innenelektroden 7-10 mit den Außenelektroden 3-6 außerdem nach den folgenden Vorschriften. Jeweils eine Innenelektrode 7 kontaktiert eine Außenelektrode 3 und die in Stapelrichtung nächsten Innenelektroden 8, 9 und 10 kontaktieren die anderen Außenelektroden 4, 5 bzw. 6, wobei gleichzeitig -wie oben beschrieben - jeweils eine Innenelektrode 7, 9 mit dem einen Anschluß 12a der Steuerspannungsquelle 11 und die in Stapelrichtung nächste Innenelektrode 8, 10 mit dem anderen Anschluß 12b der Steuerspannungsquelle 11 elektrisch verbunden werden muß, um mittels des entstehenden elektrischen Feldes den Piezoeffekt in den Piezoelementen 2 zu bewirken.

Für das in den Fig. 1 und 2A - 2D gezeigte Ausführungsbeispiel bedeutet dies im einzelnen, daß eine erste Innenelektrode 7 mit einer ersten an der ersten Seitenfläche 16 des Piezostapels angebrachten Außenelektrode 3, welche mit dem ersten Anschluß 12a der Steuerspannungsquelle 11 elektrisch verbunden ist, in Kontakt ist (Fig. 2A), die in Stapelrichtung nächste Innenelektrode 8 mit der zweiten an der zweiten Seitenfläche 17 des Piezostapels angebrachten Außenelektrode 4, welche mit dem zweiten Anschluß 12b der Steuerspannungsquelle 11 elektrisch verbunden ist, in Kontakt ist (Fig. 2B), die in Stapelrichtung nächste Innenelektrode 9 mit der dritten an der dritten Seitenfläche 18 des Piezostapels angebrachten Außenelektrode 5, welche wiederum mit dem ersten Anschluß 12a der Steuerspannungsquelle 11 elektrisch verbunden ist, in Kontakt ist (Fig. 2C), und die in Stapelrichtung nächste Innenelektrode 10 mit der vierten an der vierten Seitenfläche 19 des Piezostapels angebrachten Außenelektrode 6, welche wiederum mit dem zweiten Anschluß 12b der Steuerspannungsquelle 11 elektrisch verbunden ist, in Kontakt ist (Fig. 2D). Diese Reihenfolge der Anordnung der Innenelektroden 7-10 wird in Stapelrichtung zyklisch fortgesetzt, so daß eine über den gesamten Piezostapel gleichmäßige Verteilung der Durchkontaktierbereiche 14 erreicht wird.

Die Reihenfolge der Kontaktierungen innerhalb einer zyklischen Periode kann innerhalb der oben angegebenen allgemeinen Vorschriften prinzipiell beliebig gewählt werden. Auch ist es nicht zwingend notwendig, die Außenelektroden 3, 5 und 4, 6 einer Gruppe jeweils an gegenüberliegenden Seitenflächen 16-18 und 17-19 des Piezostacks anzubringen. Aus Gründen der Symmetrie und der damit verbundenen gleichmäßigen Verteilung der elektrischen Felder und der Zugspannungen in dem piezoelektrischen Aktor 1 ist es aber vorteilhaft, die Außenelektroden 3-6 der zwei Gruppen bzw. Polaritäten entlang des Umfanges des Piezostacks bzw. der Seitenflächen 16-19 alternierend anzuordnen.

Ferner weisen in dem oben beschriebenen Ausführungsbeispiel die piezoelektrischen Scheiben 2 eine etwa quadratische Grundfläche auf. Die Erfindung ist jedoch nicht auf diese Ausführungsform beschränkt, es sind vielmehr auch Grundflächen in rechteckiger, vieleckiger oder runder Ausgestaltung möglich. Die Anzahl der Außenelektroden 3-6 sowie die Kontaktierung der Außenelektroden 3-6 mit den Innenelektroden 7-10 erfolgt dann in analoger Weise zu dem oben näher erläuterten Ausführungsbeispiel der Fig. 1 und 2.

In Fig. 1 ist ferner beispielshaft an der Außenelektrode 3 eine Wellelektrode 20 angebracht bzw. angelötet. In entsprechender Weise sind auch die anderen drei Außenelektroden 4-6 mit einer Wellelektrode 20 versehen.

Die Wellelektroden 20 sind jeweils in den Bereichen, die in der Mitte zwischen zwei zu der jeweiligen Außenelektrode 3 durchkontaktierten Innenelektroden 7 liegen, mit der Außenelektrode 3 verlötet. Bei der oben beschriebenen zyklischen Reihenfolge der Anordnung der Innenelektroden 7-10 beträgt die Wellenlänge der Wellelektroden 20 das Vierfache des Abstandes zwischen zwei aufeinanderfolgenden Innenelektroden. Im Falle einer evtl. auftretenden Rißbildung 15 im Aktor, wie sie in Fig. 4B dargestellt ist, kann durch die Wellelektrode 20 ein in der Außenelektrode 3-6 entstandener Riß überbrückt und eine sichere Kontaktierung aller Innenelektroden 7-10 gewährleistet werden. Für die Wellelektroden wird ein Blech aus elektrisch leitfähigem Material, vorzugsweise Messing mit einer Stärke von 0,05 mm verwendet.

Im Falle eines herkömmlichen Aktors 1, wie er in Fig. 3 dargestellt ist, würde demgegenüber die Wellenlänge solcher Wellelektroden 20 nur das Zweifache des Abstands zwischen zwei aufeinanderfolgenden Innenelektroden 7, 9 betragen. Dadurch besteht die Gefahr, daß die Wellelektroden 20 vollflächig mit den Außenelektroden 3, 4 verlötet werden, so daß eine sichere Rißüberbrückung nicht gewährleistet werden kann.

## Patentansprüche

1. Piezoelektrischer Aktor (1) mit
- einer Vielzahl von Scheiben (2) aus einem piezoelektrischen Material, deren Polarisationsrichtung senkrecht zur Scheibenebene verläuft und die in Richtung ihrer Polarisationsrichtung in einer Stapelrichtung übereinander gestapelt sind,
- einer Steuerspannungsquelle (11) mit zwei Anschlüssen (12a, 12b),
- zwei Gruppen von jeweils mindestens zwei Außenelektroden (3, 5; 4, 6), wobei die Außenelektroden der ersten Gruppe (3, 5) mit dem einen ersten Anschluß (12a) der Steuerspannungsquelle (11) und die Außenelektroden der zweiten Gruppe (4, 6) mit dem zweiten Anschluß (12b) der Steuerspannungsquelle (11) elektrisch verbunden sind und die Außenelektroden (3, 4, 5, 6) jeweils an verschiedenen Seitenflächen (16, 17, 18, 19) des Stapels der piezoelektrischen Scheiben (2) angebracht sind, und
- einer Vielzahl von Innenelektroden (7, 8, 9, 10), die jeweils zwischen den piezoelektrischen Scheiben (2) angeordnet sind und die Außenelektroden (3, 4, 5, 6) alternierend derart kontaktieren, daß jeweils eine Innenelektrode (7, 9) mit dem ersten Anschluß (12a) der Steuerspannungsquelle (11) und die in Stapelrichtung nächste Innenelektrode (8, 10) mit dem zweiten Anschluß (12b) der Steuerspannungsquelle (11) elektrisch verbunden ist bis jede Außenelektrode (3, 4, 5, 6) einmal kontaktiert ist, womit ein Zyklus der Kontaktierung gebildet ist und dieser Zyklus der Kontaktierung von Innenelektroden (7-10) mit Außenelektroden (3-6) in Stapelrichtung sich wiederholt.

2. Piezoelektrischer Aktor nach Anspruch 1,
**dadurch gekennzeichnet,**
**daß** die Außenelektroden (3, 4, 5, 6) der zwei Gruppen entlang des Umfanges des Stapels alternierend angeordnet sind.

3. Piezoelektrischer Aktor nach einem der vorhergehenden Ansprüche,
**dadurch gekennzeichnet,**
**daß** die Grundflächen der piezoelektrischen Scheiben (2) eine quadratische Form aufweisen.

4. Piezoelektrischer Aktor nach einem der vorhergehenden Ansprüche,
**dadurch gekennzeichnet,**
**daß** das piezoelektrische Material ein Bleizirkonat-Bleititanat-System (PZT-System) ist.

5. Piezoelektrischer Aktor nach einem der Ansprüche 2 bis 4,
**dadurch gekennzeichnet,**
**daß** an den Außenflächen der Außenelektroden (3-6) jeweils eine Wellelektrode (20) angebracht ist.

6. Piezoelektrischer Aktor nach Anspruch 5,
**dadurch gekennzeichnet,**
**daß** die Wellenlänge der Wellelektroden (20) das Vierfache des Abstandes zwischen zwei aufeinanderfolgenden Innenelektroden (7-10) beträgt, und
**daß** die Kontaktstellen der Wellelektroden (20) mit den Außenelektroden (3-6) jeweils zwischen den Bereichen der zu der jeweiligen Außenelektrode (3-6) durchkontaktierten Innenelektroden (7-10) angeordnet sind.

## Claims

1. Piezoelectric actuator (1) with
- a multiplicity of plates (2) of a piezoelectric material, the polarization direction of which runs perpendicular to the plate plane and which are stacked one on top of the other in a stacking direction in the direction of their polarization direction,
- a control voltage source (11) with two terminals (12a, 12b),
- two groups of in each case at least two external electrodes (3, 5; 4, 6), the external electrodes of the first group (3, 5) being electrically connected to the one first terminal (12a) of the control voltage source (11) and the external electrodes of the second group (4, 6) being electrically connected to the second terminal (12b) of the control voltage source (11), and the external electrodes (3, 4, 5, 6) being respectively attached to different side faces (16, 17, 18, 19) of the stack of piezoelectric plates (2), and
- a multiplicity of internal electrodes (7, 8, 9, 10), which are respectively arranged between the piezoelectric plates (2) and alternately contact the external electrodes (3, 4, 5, 6) in such a way that in each case an internal electrode (7, 9) is electrically connected to the first terminal (12a) of the control voltage source (11) and the next internal electrode (8, 10) in the stacking direction is electrically connected to the second terminal (12b) of the control voltage source (11), until each external electrode (3, 4, 5, 6) is contacted once, whereby a cycle of contacting is formed and this cycle of contacting of internal electrodes (7-10) with external electrodes (3-6) is repeated in the stacking direction.

2. Piezoelectric actuator according to Claim 1, **characterized in that** the external electrodes (3, 4, 5, 6) of the two groups are arranged in an alternating manner along the circumference of the stack.

3. Piezoelectric actuator according to one of the preceding claims, **characterized in that** the base areas of the piezoelectric plates (2) have a square form.

4. Piezoelectric actuator according to one of the preceding claims, **characterized in that** the piezoelectric material is a lead-zirconate/lead-titanate system (PZT system).

5. Piezoelectric actuator according to one of Claims 2 to 4, **characterized in that** a corrugated electrode (20) is respectively attached to the outer faces of the external electrodes (3-6).

6. Piezoelectric actuator according to Claim 5, **characterized in that** the wavelength of the corrugated electrodes (20) is four times the distance between two successive internal electrodes (7-10), and **in that** the contact points of the corrugated electrodes (20) are respectively arranged with the external electrodes (3-6) between the regions of the internal electrodes (7-10) contacted through to the respective external electrodes (3-6).

## Revendications

1. Actionneur piézoélectrique (1) comportant
- plusieurs disques (2) constitués d'un matériau piézoélectrique, dont la direction de polarisation s'étend perpendiculairement au plan des disques et qui sont empilés les uns sur les autres dans la direction de leur direction de polarisation,
- une source d'alimentation de commande (11) dotée de deux raccords (12a, 12b),
- deux groupes de respectivement au moins deux électrodes externes (3, 5 ; 4, 6), où les électrodes externes du premier groupe (3, 5) sont reliées électriquement au premier raccord (12a) de la source d'alimentation de commande (11) et les électrodes externes du deuxième groupe (4, 6) sont reliées électriquement au deuxième raccord (12b) de la source d'alimentation de commande (11) et les électrodes externes (3, 4, 5, 6) sont respectivement montées au niveau de surfaces latérales différentes (16, 17, 18, 19) de l'empilement de disques piézoélectriques (2), et
- plusieurs électrodes internes (7, 8, 9, 10), qui sont respectivement disposées entre les disques piézoélectriques (2) et qui entrent en contact avec les électrodes externes (3, 4, 5, 6), de telle sorte que respectivement une électrode interne (7, 9) est reliée électriquement au premier raccord (12a) de la source d'alimentation de commande (11) et l'électrode interne suivante (8, 10) dans la direction de l'empilement est reliée électriquement au deuxième raccord (12b) de la source d'alimentation de commande (11), jusqu'à ce que chaque électrode externe (3, 4, 5, 6) ait un contact, ce qui permet de former un cycle de contact et de répéter ce cycle de contact entre les électrodes internes (7-10) et les électrodes externes (3-6) dans la direction de l'empilement.

2. Actionneur piézoélectrique selon la revendication 1,
**caractérisé en ce que**
les électrodes externes (3, 4, 5, 6) des deux groupes sont disposées de façon alternée le long de la périphérie de l'empilement.

3. Actionneur piézoélectrique selon l'une des revendications précédentes,
**caractérisé en ce que**
les surfaces de base des disques piézoélectriques (2) présentent une forme carrée.

4. Actionneur piézoélectrique selon l'une des revendications précédentes,
**caractérisé en ce que**
le matériau piézoélectrique est un système titanate zirconate de plomb (système PZT).

5. Actionneur piézoélectrique selon les revendications 2 à 4,
**caractérisé en ce que**
respectivement une électrode ondulée (20) est montée au niveau des surfaces extérieures des électrodes externes (3-6).

6. Actionneur piézoélectrique selon la revendication 5,
**caractérisé en ce que**
la longueur d'ondulation des électrodes ondulées (20) correspond à quatre fois la distance entre deux électrodes internes successives (7-10), et
les points de contact des électrodes ondulées (20) avec les électrodes externes (3-6) sont disposés respectivement entre les zones des électrodes internes (7-10) en contact avec les électrodes externes respectives (3-6).
